Europäisches Patentamt

European Patent Office

Office européen des brevets

(19)

(11) Publication number: 0 367 443
A1

# EUROPEAN PATENT APPLICATION

(21) Application number: 89310707.8

(22) Date of filing: 18.10.89

(51) Int. Cl.5 G11C 11/22 , G11C 11/34 , G11C 11/24

A request for correction on page 16, claim 5 should be renumberd claim 4 has been filed pursuant to Rule 88 EPC. A decision on the request will be taken during the proceedings before the Examining Division (Guidelines for Examination in the EPO, A-V, 2.2).

(30) Priority: 31.10.88 US 265384

(43) Date of publication of application:
09.05.90 Bulletin 90/19

(84) Designated Contracting States:
DE FR GB IT

(71) Applicant: RAYTHEON COMPANY
141 Spring Street
Lexington Massachusetts 02173(US)

(72) Inventor: Rallapalli, Krishna
3184 Linkfield Way
San Jose California 95135(US)

(74) Representative: Jackson, David Spence et al
REDDIE & GROSE 16, Theobalds Road
London, WC1X 8PL(GB)

(54) Ferroelectric memory.

(57) A non-volatile memory comprises an array of ferroelectric capacitors (202A, 202B,.....) each connected to one row and one column select line (R$_1$, R$_2$,..., C$_1$, C$_2$,...) through a network of four diodes (D$_1$, D$_2$, D$_3$, D$_4$). The select lines are connected to a power supply (V) or ground to access one of the cells. The diodes (D$_1$, D$_2$, D$_3$, D$_4$) are configured to provide a conducting path between a power supply (V) and ground including the accessed cell while isolating all other cells from the power supply (V) and ground. Each select line (R$_1$, R$_2$,...; C$_1$, C$_2$,...) comprises two control lines (R$_1$+, R$_1$-,...;C$_1$+, C$_1$-,...) driven by a respective row or column driver circuit (12$_1$,...; 18$_1$,...) which includes two bipolar switching transistors (Q$_{iA}$, Q$_{iB}$,) respectively controlling the two control lines. A read operation consists of writing logic 1 into the accessed cell to obtain an output voltage from a resistor 204 of a current sensor 22, and then writing the read-out bit back into the accessed cell if that cell stored a logic 0.

FIG. 2

## FERROELECTRIC MEMORY

Background of the Invention

The invention relates generally to semiconductor memories and more particularly to non-volatile ferroelectric memories.

Semiconductor memories are widely used in many digital systems. These memories generally contain an array of memory cells fabricated on a semiconductor substrate. A plurality of row select lines, and a plurality of column select lines are connected to the memory cells. One memory cell is connected at the intersection of each row select line and each column select line.

By applying a signal to one row select line and one column select line, the memory cell at the intersection of those lines can be accessed. An access may consist of "reading" or "writing" to the memory cell. Each memory cell is constructed to store one bit of information, and the binary value of the bit stored in a cell can be altered during a write operation or placed on an output line during a read operation.

Many memory cells are constructed such that power must be continuously applied in order for the cell to maintain the stored information. In some systems, however, it is important for information to be retained even when power to the system is turned off. In those systems, non-volatile memory cells are used.

Ferroelectric materials have been used for non-volatile memory cells. For example, patent numbers 4,713,157 issued in the name of McMillan et al., and 4,707,897 issued in the name of Rohrer et al., disclose ferroelectric semiconductor memories. As is known, ferroelectric materials become polarized when they are placed in a sufficiently strong electric field. Importantly for use in non-volatile memories, ferroelectrics maintain this polarization when removed from the electric field. In fact, an ideal ferroelectric maintains the polarization until placed in a sufficiently strong electric field of the opposite polarity.

When used in memory cells, the ferroelectric material is formed into a structure which operates as a capacitor. The "capacitor" is connected between the row and column select lines. An electric field through the ferroelectric material in a memory cell is created by a voltage applied across the select lines which access that memory cell. A positive voltage exceeding a particular value, called the coercive threshold voltage, polarizes the ferroelectric in a positive direction. A negative voltage exceeding the coercive threshold voltage polarizes the ferroelectric material in the negative direction.

To store a bit having a logic "1" in the cell, a positive voltage is applied. To store a bit having a logic "0", a negative voltage is applied.

To read out the information in a cell, a positive voltage exceeding the coercive threshold voltage is applied and the current flow into the cell is measured. When the cell has a negative polarization and a positive voltage is applied, the polarization changes. A substantial displacement current flows into the cell. Thus, a large current flow during the read indicates a logic 0 stored in the cell. Conversely, a very small current flow during the read operation indicates a logic 1.

After the positive voltage is applied to read the cell, the cell stores a logic 1 regardless of what value was stored before the reading (i.e. a destructive read out). Thus, each time a cell is read out, the value stored in the memory must be detected and written into the memory cell. Ferroelectric memories, therefore, contain control logic which restores the value read from the cell back into the cell after the read operation.

Since semiconductor memories contain numerous cells, voltages must only be applied across the selected cell during a read or write operation. When no cells are being accessed, all the select lines are at the reference potential. To access a cell joining a particular row and a particular column select line, a positive voltage equal to one-half the coercive threshold voltage is applied to one select line and a negative voltage also equal to one-half of the coercive threshold voltage is applied to the other select line. A voltage equal to the coercive threshold voltage is thus applied across the selected cell. The polarity of the applied voltage is determined by whether the positive or negative voltage is applied to the row or column select line.

The maximum voltage which develops across any cell other than the selected cell is one-half the coercive threshold voltage. For an ideal ferroelectric material, such a voltage should have no effect because a voltage exceeding the coercive threshold voltage must be applied to change the polarization of the ferroelectric material. In real ferroelectrics, however, such an applied voltage causes what is known as a "half select phenomenon". The polarization of the cells exposed to even one-half the coercive threshold voltage gradually changes. These gradual changes in polarization may disrupt information stored in the memory in an unpredictable manner and are thus undesirable.

An additional drawback of existing ferroelectric semiconductor memories is that both a positive and negative voltage source are required. Having both polarity voltage sources requires components which can handle both polarities to drive the select lines. CMOS devices are symmetrical and can handle both polarities of voltage and are generally used. In some cases, however. it would be desirable to use bipolar devices which do not easily handle both polarities of voltage.

## Summary of the Invention

It is an object of this invention to provide a ferroelectric memory structure which does not exhibit the half selected phenomenon.

It is also an object of this invention to provide a ferroelectric memory structure which requires only one polarity voltage source.

It is yet another object of this invention to provide a ferroelectric memory structure requiring only components fabricated in bipolar technologies.

The foregoing and other objects of this invention are achieved by an array of ferroelectric memory cells wherein each row and each column select line comprises two lines: a first control line switchably coupled to ground through a bipolar transistor; and a second control line connected to a positive voltage source which can be switchably grounded through a bipolar transistor. A first side of each ferroelectric memory cell is connected to the first control line of the column control bus via a diode having its anode coupled to the cell and to the second control line of the column select line via a diode having its cathode coupled to the cell. A second side of each ferroelectric memory cell is connected to the first control line of the row select line via a diode having its anode coupled to the cell and to the second control line of the row select line bus via a diode having its cathode coupled to the cell.

## Brief Description of the Drawings

With the foregoing background in mind, the invention will be better understood by reference to the following more detailed description and the accompanying drawings in which:

FIG. 1 is a block diagram of a ferroelectric semiconductor memory constructed according to the present invention; and

FIG. 2 is a schematic, greatly simplified, of exemplary ones of the memory cells, control buses, column drives and row drives of the semiconductor memory of FIG. 1.

## Description of the Preferred Embodiments

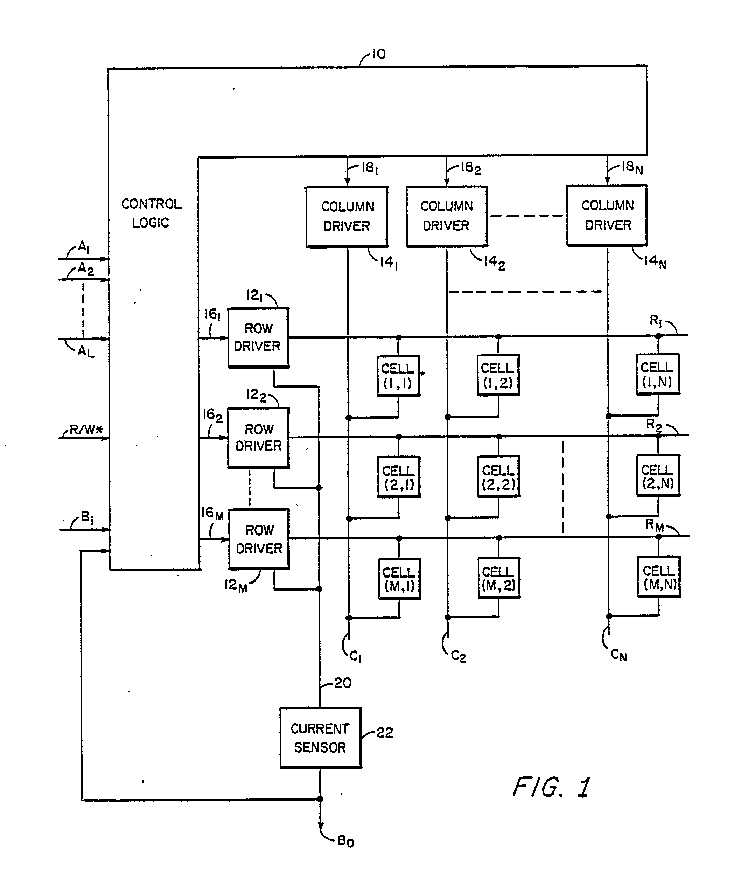

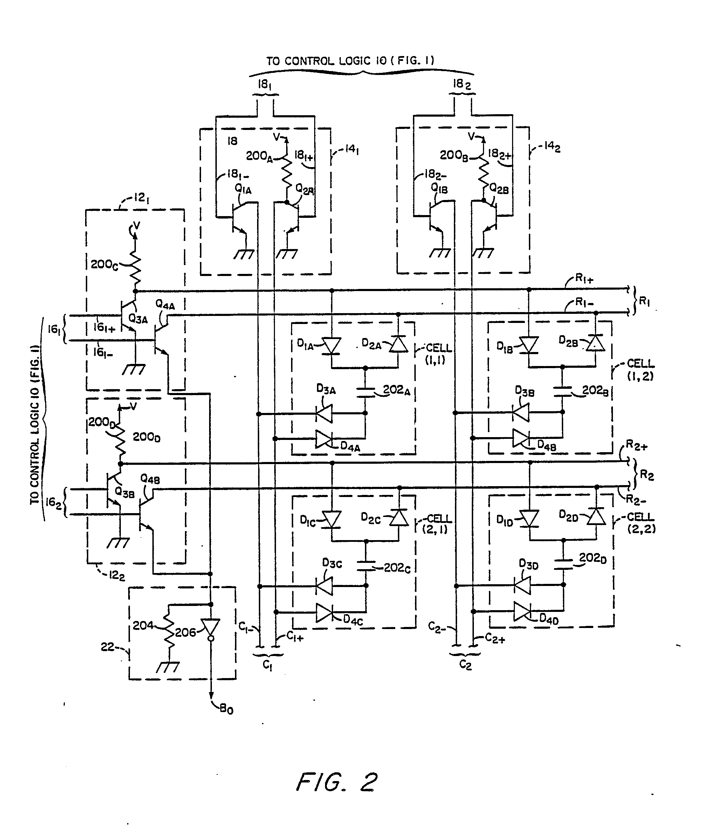

FIG. 1 is a block diagram of a semiconductor memory fabricated according to the present invention. One skilled in the art will understand that the memory is fabricated on a semiconductor substrate according to well known processes. The block diagram does not show standard elements of semiconductor circuits such as power and ground connections, and standard elements of memory circuits, such as latches and buffers, but it is understood that such elements are required.

The memory contains a plurality of row select lines $R_1...R_M$ and a plurality of column select lines $C_1...C_N$. Memory cells $(1, 1)...(M, N)$, described in greater detail below, are connected between the select lines. Row drivers $12_1...12_M$ and column drivers $14_1...14_N$, described in greater detail below, couple signals onto the select lines $C_1...C_N$ and $R_1...R_M$ to access a selected one of the memory cells $(1, 1)...(M, N)$. Row drivers $12_1...12_M$ and column drivers $14_1...14_N$ in turn receive control signals $16_1...16_M$ and $18_1...18_N$, respectively, from control logic 10.

Control logic 10 consists of known logic elements to respond to input signals and generate the control signal $16_1...16_M$ and $18_1...18_M$. Address inputs $A_1...A_L$ represent the particular one of the memory cells $(1, 1)...(M, N)$ to be accessed. Control logic 10 decodes the address inputs $A_1...A_L$ to determine in which row and in which column the selected one of the memory cells $(1, 1)...(M, N)$ resides. Control logic 10 then sets the value of the control signals $16_1...16_M$ and $18_1...18_M$ corresponding to that row and column.

The values of the control signals produced by control logic 10 also depend on the inputs R/W* and $B_i$. When input R/W* has a value of logic 1, control logic 10 sets the values of control signals $16_1...16_M$ and $18_1...18_N$ to store the value of input $B_i$ into the accessed one of the cells $(1, 1)...(M, N)$. Conversely, when input R/W* has a value of logic 0, the value stored in the accessed one of the cells $(1, 1)...(M, N)$ is read and appears at output $B_o$.

The memory of FIG. 1 performs a destructive read. To perform a read operation, control logic 10 first generates values of control signals $16_1...16_M$ and $18_1...18_M$ to write a logic 1 into the accessed one of the memory cells $(1, 1)...(M, N)$. If the accessed cell stored a logic 0, a measurable current flows in line 20. Current sensor 22 measures the current flow in line 20 and produces a value on output line $B_o$ indicating a logic 0 when a current is detected and a logic 1 when no current is detected.

To prevent the information in the accessed memory cell from being lost during a read operation, control logic 10 next generates values of control signals $16_1...16_M$ and $18_1...18_M$ to write the

value of $B_o$ back into the accessed cell.

Turning now to FIG. 2, additional details of the memory of FIG. 1 may be seen. Details of memory cells (1, 1), (1, 2), (2, 1) and (2, 2) are shown as exemplary of memory cells (1, 1)...(M, N); details of row driver 12· and 12$_2$ are shown as exemplary of the row drivers 12·...12$_M$; and details of column driver 14$_1$ and 14$_2$ are shown as exemplary of the column drivers 14$_1$...14$_N$. Select lines R$_1$, R$_2$, C$_1$ and C$_2$ are also shown to comprise two control lines each. R·+ and R·−, R$_2$+ and R$_2$−, and C$_1$+ and C$_1$−, respectively.

Considering memory cell (1, 1) as illustrative, memory cell (1, 1) comprises ferroelectric capacitor 202$_A$. Capacitor 202$_A$ is formed using known techniques. For example, U.S. Patent No. 4,713,157 issued to McMillan et al. describes a method of forming two conductive layers with a layer of ferroelectric material in betweeen. The conductive layers form the plates of capacitor 202$_A$ and the ferroelectric material forms the dielectric.

Diodes D$_{1A}$...D$_{4A}$ connect the plates of capacitor 202$_A$ to control buses R$_1$ and C$_1$. Diodes D$_{1A}$...D$_{4A}$ are formed, also using known techniques, in a semiconductor substrate (not shown). The diodes are oriented so that signals on both select lines R$_1$ and C$_1$ are required to access memory cell (1, 1).

Row driver 12 and column driver 18, which produce the required control signals on select lines R$_1$ and C$_1$, each consist of two transistors, Q$_{3A}$ and Q$_{4A}$ and Q$_{1A}$ and Q$_{2A}$, respectively. Transistors Q$_{1A}$, Q$_{2A}$, Q$_{3A}$ and Q$_{4A}$ switch in response to control signals 18$_1$−, 18$_1$+, 16$_1$+ and 16$_1$−, respectively. For simplicity, each transistor can be thought of as an open circuit when a logic low voltage is applied to its corresponding control line and as a short circuit when a logic high voltage is applied to its corresponding control line. The values of control signals 16$_1$+, 16$_1$−, 18$_1$+ and 18$_1$− are set by control logic 10 (FIG. 1) to access the individual memory cells (1, 1)...(M, N).

In quiescent operation, i.e. when memory cell (1, 1) is not being accessed, control signals 16$_1$− and 18$_1$− are at a logic low voltage and control signals 16$_1$+ and 18$_1$+ are at a logic high voltage. Control lines R$_1$− and C$_1$− are thus floating, i.e. they are disconnected from ground. Control lines R$_1$+ and C$_1$+ are connected to ground. A little thought reveals that no voltage is applied across capacitor 202$_A$ in the quiescent state.

To store a logic 0 in memory cell (1, 1), control signal 16$_1$+ is placed at a logic low voltage and control signal 18$_1$− is placed at a logic high voltage. Control line R$_1$+ is thus connected to the power supply V through resistor 200$_C$. Here, resistor 200$_C$ is selected to have a value small enough that the voltage dropped across the resistor is relatively small. Control line C·− is connected to ground through transistor Q$_{1A}$. Diodes D$_{1A}$ and D$_{3A}$ are therefore forward biased. A voltage approximately equal to the power supply V voltage is therefore developed across capacitor 202$_A$. Provided the power supply voltage V exceeds the coercive threshold voltage, the ferroelectric material in capacitor 202$_A$ is polarized in a negative direction.

It is important to note that capacitors in other memory cells, such as capacitors 202$_B$, 202$_C$ and 202$_D$ are not affected because no conducting path exists incorporating those capacitors. No current can flow to the capacitors and no voltage is applied across them. For example, even though control line R$_1$+ is at the power supply V voltage, no voltage develops across capacitor 202$_B$. Control line C$_2$− is floating because control signal 18$_2$− is a logic low. Even though control line C$_2$+ is at ground, diode D$_{4B}$ is reverse biased. Thus, no path for current flows through capacitor 202$_B$ and no voltage is developed across it. Thus, when capacitor 202$_A$ is polarized, no voltage is applied across any other capacitor.

To maintain the stored level, the control signals 18$_1$− and 16$_1$+ are returned to the quiescent condition. The polarization of capacitor 202$_A$ is thereby maintained.

To store a logic 1 in memory cell (1, 1) or to read the value stored in the cell, control signal 18$_1$+ is placed at a logic low voltage and control signal 16$_1$− is placed at a logic high voltage. Control line C$_1$+ is connected to the power supply V through resistor 200$_A$ and control line R$_1$− is connected to ground through transistor Q$_{4A}$ and resistor 204. Here, the value of resistor 200$_A$ is selected to be small enough so that a relatively small voltage is dropped across the resistor 200$_A$. The value of resistor 204 is also selected to be small enough so that a relatively small voltage is dropped across the resistor 204. A conducting path exists through diodes D$_{4A}$ and D$_{2A}$. A voltage having a magnitude approximately equal to the power supply V voltage is developed across capacitor 202$_A$. The polarity of the voltage is opposite the polarity developed when a logic 0 is stored in memory cell (1, 1). The cell is thus positively polarized, which represents storage of a logic 1.

In storing a logic 1 in cell (1, 1) or reading the value stored in cell (1, 1), the conducting path between the power supply V and ground includes resistor 204. If the cell contains a logic "0", then a change in the polarization of the ferroelectric material in capacitor 202$_A$ occurs, and a displacement current flows through resistor 204. Therefore, a voltage is developed across resistor 204 when a logic 1 is written into a memory cell where the cell had previously stored a logic 0. The voltage across resistor 204, if read while a logic 1 is being written to a cell, indicates the value stored in the cell. Amplifier 206 has as its input the value of the voltage across resistor 204. The output of amplifier 206 is the output $B_o$.

One bit of information can be stored in any of the other memory cells (1, 2)...(M, N) in a similar fashion. For example, cell (1, 2) is accessed via control signals $16_1+$, $16_1-$, $18_2+$, and $18_2-$. Control signal $18_2+$ is controlled as control signal $18_1+$ and control signal $18_2-$ is controlled as control signal $18_1-$ to access cell (1, 1).

Having described one embodiment of the invention, other embodiments will become apparent to one of skill in the art. For example, the semiconductor memory could be augumented to store a plurality of bits for each address. In another embodiment, current sensor 22 could be formed from a transconductance amplifier in place of resistor 204. In another embodiment, CMOS or FETs could be used in place of bipolar junction transistors for driving the select lines instead of the simple transistors used in this example. It is felt, therefore, that the scope of the invention should be limited only by the appended claims.

## Claims

1. An improved memory comprising:

(a) a row select line comprising a first control line and a second control line;

(b) a column select line comprising a first control line and a second control line;

(c) a ferroelectric capacitor having a first terminal and a second terminal, wherein:

i) said first terminal is connected to the first control line of the row select line via a first diode having its cathode coupled to the first terminal;

ii) said first terminal is connected to the second control line of the row select line via a second diode having its anode coupled to the first terminal;

iii) said second terminal is coupled to the second line of the column select line via a third diode having its anode coupled to the second terminal; and

iv) said second terminal is coupled to the first line of the column select line via a fourth diode having its cathode coupled to the second terminal.

2. The improved memory of Claim 1 further comprising:

(a) a column driver comprising:

i) a first transistor connecting the second line of the column select line to ground in response to a first column control signal having a first value;

ii) a resistor connecting the first line of the column select line to a power supply; and

iii) a second transistor connecting the first ine of the column select line to ground in response to a second column control signal having a first value; and

(b) a row driver comprising:

i) a resistor connecting the first control line of the row select line to the power supply;

ii) a third transistor for connecting the first control line of the row select line to ground in response to a first row control signal having a first value;

iii) a fourth transistor for connecting the second control line of the row select line to ground in response to a second row control signal having a first value.

3. The improved memory cell in Claim 2 further comprising logic means for producing control signals to:

(a) polarize the ferroelectric capacitor to a first state, such control signals comprising:

i) the first column control signal having the first value; and

ii) the second column control signal having the first value; and

(b) polarize the ferroelectric capacitor to a second state, such control signals comprising:

i) the first row control signal having the first value; and

ii) the second row control signal having the first value.

4. An improved memory comprising:

(a) a plurality of cells, each of such cells having a first terminal and a second terminal and comprising ferroelectric material; and

(b) means for applying a voltage exceeding the coercive threshold across a selected one of the plurality of cells while applying substantially no voltage across all of the others of the plurality of cells.

FIG. 1

FIG. 2

| | **DOCUMENTS CONSIDERED TO BE RELEVANT** | | EP 89310707.8 |
|---|---|---|---|
| Category | Citation of document with indication, where appropriate, of relevant passages | Relevant to claim | CLASSIFICATION OF THE APPLICATION (Int. Cl.)Ⅹ 5 |
| A | US - A - 4 360 896 (BRODY) * Abstract; column 3, line 4 - column 4, line 6; fig. 3,5 * -- | 1,5 | G 11 C 11/22 G 11 C 11/34 G 11 C 11/24 |
| A | GB - A - 1 461 683 (WESTERN ELECTRIC COMPANY) * Page 1, lines 42-66; page 1, lines 74-81; page 2, lines 64-68 * -- | 1,5 | |
| A | DE - A - 2 034 169 (IBM) * Page 4, line 23 - page 5, line 2; page 6, line 18 - page 7, line 20; fig. 3,4 * -- | 1 | |
| A | EP - A2 - 0 278 167 (RAMTRON) * Abstract; column 6, lines 11-18; column 10, lines 17-29; fig. 3,5; claim 1 * -- | 1,5 | TECHNICAL FIELDS SEARCHED (Int. Cl.)Ⅹ 5 G 11 C H 01 L |
| A | EP - A2 - 0 170 286 (TOSHIBA) * Abstract; page 17, lines 10-20; claim 1 * ---- | 1 | |

The present search report has been drawn up for all claims

| Place of search | Date of completion of the search | Examiner |
|---|---|---|
| VIENNA | 15-02-1990 | BRUNNER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82